# EUROPÄISCHE PATENTANMELDUNG

(11) **EP 0 909 026 A2**
(43) Veröffentlichungstag der Anmeldung: **14.04.1999**
(21) Anmeldenummer: 98118771.9
(22) Anmeldetag: 05.10.1998
(51) Int. Cl.: H03H 9/64

(54) **Akustisches Filter, insbesondere Oberflächenwellen-Filter**

(30) Priorität: 10.10.1997 DE 19744948
(71) Anmelder: SIEMENS AKTIENGESELLSCHAFT, 80333 München (DE)
(72) Erfinder: Johannes, Thomas, Dr., 81925 München (DE)

(57) **Zusammenfassung**

Akustischer Wellenleiter, insbesondere OFW-Filter (10) mit einem IDT-Wandlerbereich (f) bevorzugt großer Apertur, wobei die Phasengeschwindigkeit (vph) im transversal an den IDT-Wandlerbereich (f) angrenzenden äußeren gitterstrukturierten Bereich (g) auf einen Betrag eingestellt ist, der zwischen der Phasengeschwindigkeit im IDT-Wandlerbereich und der höheren Phasengeschwindigkeit im Bereich des Wellenleiters mit freier, nichtmetallisierter Oberfläche liegt.

## Beschreibung

Die Erfindung betrifft ein akustisches Filter, insbesondere Oberflächenwellen-Filter gemäß dem Oberbegriff des Patentanspruches 1.

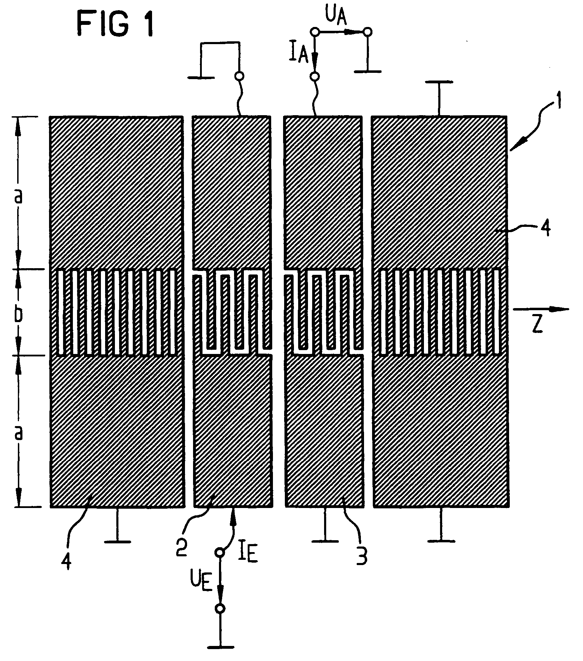

In Oberflächenwellen-Filtern - so z.B. in einem bekannten 2-Tor-Resonator gemäß schematischer Darstellung nach Fig. 1 - erfolgt die elektrische Kontaktierung der zur Anregung und Detektion akustischer Wellen benötigten interdigitalen Einund Ausgangswandler 2, 3 mit den äußeren elektrischen Anschlußelementen bzw. Zuleitungen über im Bereich 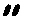 a" angeordneten Sammelschienen, auch Pads genannt. Die Ein- und Ausgangstore dieses Filters sind dabei entsprechend mit I_{E}U_{E} bzw. I_{A}U_{A} bezeichnet.

Die Ausbreitungsgeschwindigkeiten, im folgenden stets Phasengeschwindigkeiten (Vph) genannt, der akustischen Wellen in Ausbreitungsrichtung 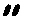 z" des Filters sind - was im übrigen für sämtliche Wellenleiter und folglich OFW-Filter gilt - im Gitterbereich 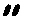 b" der IDT-Wandler 2, 3 und Reflektoren 4, 4, im Bereich 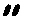 a" der Sammelschienen und im Bereich der freien, nicht mit metallischen Strukturen behafteten Oberfläche unterschiedlich.

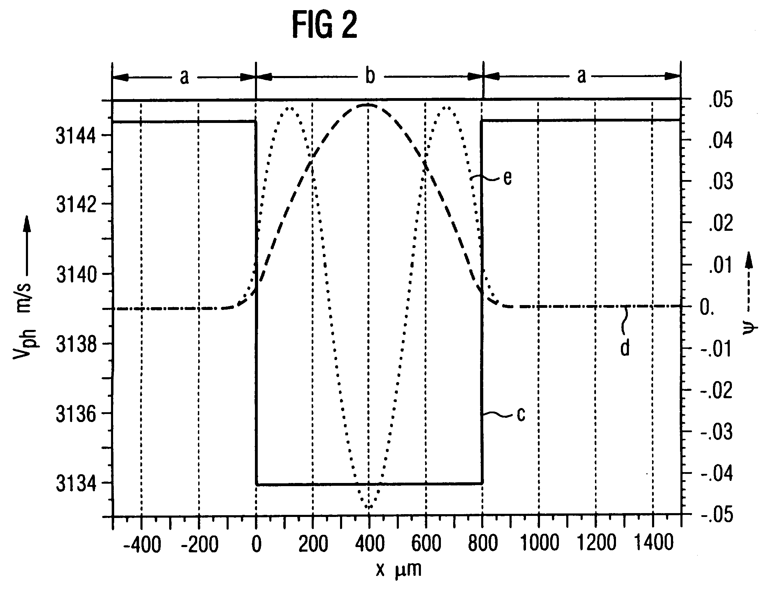

Siehe hierzu Fig. 2, in der die Phasengeschwindigkeit, gemessen in m/s, über der Filter-Transversalen 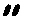 x", gemessen in µm, aufgetragen ist, für ein Filter gemäß Fig. 1, das einen speziellen Quarz-Kristallschnitt besitzt (Rayleigh-Wellen) mit aufgedampften Al-Finger- und Sammelschienen.

Die ausgezogene Linie 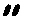 c" gibt dabei im Idealfall die Phasengeschwindigkeit einer unendlich ausgedehnten ebenen Welle im Filter wieder, die in den Sammelschienenbereichen 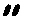 a", die sich transversal über 500 µm bzw. 700 µm erstrecken, knapp über dem hohen Wert von 3144 m/s liegt und im Bereich 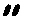 b" der IDT-Wandler auf den wesentlich niedrigeren Wert von etwa 3134 m/s absinkt.

Durch dieses transversale Phasengeschwindigkeits-Profil werden im IDT-Wandlerbereich 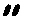 b" angeregte Moden (Wellen) unterschiedlicher Phasengeschwindigkeit im gedachten Idealfall verlustlos ausbreitungsfhähig geführt, d.h. es erfolgt keine Abstrahlung der Moden aus dem durch das gegebene Phasengeschwindigkeits-Profil definierten Wellenleiter bzw. OWF-Filter nach außen. Absorptions- und Streuverluste sowie Abstrahlungsverluste durch die Reflektoren können jedoch trotzdem vorhanden sein.

Der Entwurf derartiger Bauteile, d.h. Wellenleiter und insbesondere OFW-Filter, erfolgt üblicherweise auf der Grundlage nur einer definierten Phasengeschwindigkeit für eine vorgegebene beliebige Längskoordinate 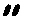 z" des Bauteils. Diese Phasengeschwindigkeit Vph entspricht sinnvollerweise dem in Fig. 2 durch die strichlinierte Kurve 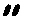 d" dargestellten Modus mit der Ordnungszahl 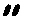 0", da dieser durch die IDT-Wandler am stärksten angeregt wird und somit das elektrische Verhalten zwischen den Ein- und Ausgangstoren dominiert. Dieses gewünschte elektrische Verhalten wird durch eine Admittanzmatrix YO beschrieben, die den Beitrag des Grundmodus (Ordnungszahl 0) zur Admittanzmatrix des Gesamt-2-Tor-Resonators kennzeichnet. Zusätzlich vorhandene Moden gerader Ordnungszahlen, d.h. Moden mit der Ordnungszahl entsprechender Anzahl von Nulldurchgängen, der in Fig. 2 dargestellten Profilfunktion - s. z.B. den in Fig. 2 punktiert eingetragenen Modus der Ordnungszahl 2 - führen zu weiteren Beiträgen zur Admittanzmatrix des Gesamt-2-Tor Resonators 1. Diese Zusätzlichen Beiträge werden wiederum durch die Admittanzmatrizen Y2, y4 und folgende charakterisiert. Moden mit ungerader Ordnungszahl werden von den IDT-Wandlern aus Symmetriegründen nicht angeregt, gleichwohl werden sie grundsätzlich ebenfalls im Wellenleiter geführt.

Da, wie bereits erwähnt wurde, sich die Moden durch ihre verschiedene Phasengeschwindigkeit voneinander unterscheiden, führt deren Überlagerung zu einer Abweichung vom gewünschten Verhalten des Bauelements, z.B. Filters, was sich in der Praxis z.B. durch Einbrüche im Durchlaßbereich der Bauelemente bzw. in einer Reduktion der Sperrselektion äußert.

Zwar ist es möglich, die transversale Ausdehnung der IDT-Wandler so weit zu reduzieren, daß Moden mit höherer Ordnungszahl als 1 nicht mehr verlustfrei geführt werden, jedoch ist damit eine verringerte Anregung der akustischen Wellen bzw. Moden verbunden, woraus wiederum ein im allgemeinen unerwünscht hohes Impedanzniveau der Bauelemente resultiert.

Der Erfindung liegt nun die Aufgabe zugrunde, eine Lehre zur Schaffung von Wellenleitern, insbesondere von OFW-Filtern, anzugeben, die sich durch möglichst große Apertur und damit hohe Anregung akustischer Wellen im IDT-Wandlerbereich auszeichnen bei gleichzeitig geschaffener Möglichkeit, ausschließlich Moden (Wellen) erwünscht niedriger Ordnung verlustlos zu führen.

Zur Lösung dieser Aufgabe sieht die Erfindung bei einem Wellenleiter, insbesondere OFW-Filter, gemäß Oberbegriff des Patentanspruchs 1 vor, daß die Phasengeschwindigkeit im transversal an den IDT-Wandlerbereich angrenzenden äußeren Bereich auf einen Betrag eingestellt ist, der zwischen der Phasengeschwindigkeit im IDT-Wandlerbereich und der höheren Phasengeschwindigkeit im Bererich des Wellenleiters mit freier, nichtmetallisierter Oberfläche liegt.

Im konkreten Einzelfall bedeutet dies, daß die Phasengeschwindigkeit im transversal an den IDT-Wandlerbereich angrenzenden Bereich auf einen Betrag abgesenkt ist, bei dem im IDT-Wandlerbereich nur Moden erwünschter niedriger Ordnung, d.h. zumindest der Grundmodus verlustlos geführt sind und somit die Einfügedämpfung des Bauelements, insbesondere bei hochgradig resonanten Bauelementen niedrig gehalten ist.

Die vorstehende Lösung gewährleistet bei Vorgabe einer ausreichend hohen IDT-Wandlerbreite bzw. Apertur, daß am transversalen Übergang vom IDT-Wandlerbereich in die transversal angrenzenden und letztlich in die Sammelschienen überleitenden Bereiche keine Beeinträchtigung der FilterÜbertragungseigenschaften durch höhere unerwünschte Moden bzw. Total- oder partielle Reflexionen dieser Moden erfolgt.

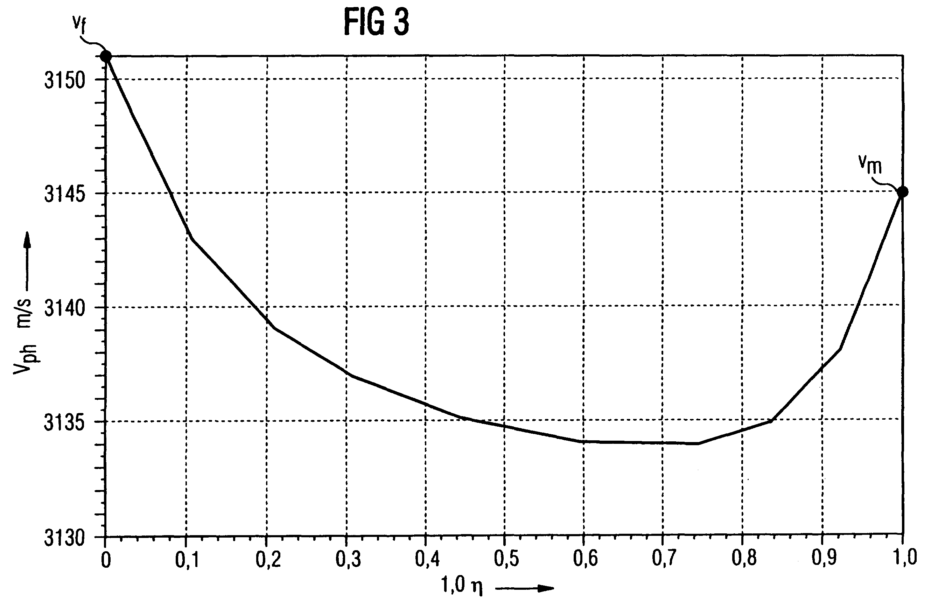

Wie Fig. 3 zu entnehmen ist, in der die Phasengeschwindigkeit Vph als Funktion des Metallisierungsverhältnisses η, d.h. des Verhältnisses von Fingerbreite im Wandler zu Fingerperiode des IDT-Wandlergitters aufgetragen ist, kann im Sinne obiger Vorschläge die Einstellung der Phasengeschwindigkeit im transversal an den IDT-Wandlerbereich angrenzenden äußeren Bereich, durch eine hier angeordnete Gitterstruktur erfolgen, deren Metallisierungsverhältnis entsprechend der gewünschten Phasengeschwindigkeit in diesem Bereich gewählt und entsprechend niedriger ist als das mit 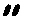 1" angegebene Metallisierungsverhältnis im Sammelschienenbereich.

Durch eine Verringerung bzw. Erhöhung des Metallisierungsverhältnisses η im neu entstandenen Gitterbereich läßt sich so - s. Fig. 3 - jede Phasengeschwindigkeit zwischen der im gegebenen IDT-Wandlerbereich und den Phasengeschwindigkeiten v_{f} und vₘ im Bereich der freien Oberfläche bzw. der Sammelschienen einstellen. Typische IDT-Wandler sind dabei mit Metallisierungsverhältnissen zwischen η = 0,5 bis 0,7, also für vergleichsweise niedrige Phasengeschwindigkeit ausgeführt.

Vorstehende Ausführungen zeigen also, daß durch ein geeignetes Metallisierungsverhältnis im äußeren Gitterbereich der Unterschied zwischen den Phasengeschwindigkeiten im IDT-Wandlerbereich und angrenzenden Gitterbereich so weit herabgesetzt werden kann, bis nur noch die erwünschten Moden verlustfrei geführt sind. Um eine hohe Führung des Grundmodus zu erzielen, wird man dabei auch den unsymmetrischen Modus der Ordnungszahl 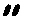 1" noch zulassen. Aus Gründen der Symmetrie wird dieser nämlich nicht angeregt und kann somit auch nicht strahlen.

Weitere Merkmale der Erfindung sind den Unteransprüchen, der Zeichnung und ihrer Beschreibung entnehmbar. Es zeigt jeweils in schematischer und aus Gründen der Übersichtlichkeit nicht maßstabsgetreuer Darstellung:
- Fig. 4:: das erfindungsgemäß abgewandelte Ausführungsbeispiel eines 2-Tor-Resonators nach Fig. 1;
- Fig. 5:: die Profilfunktion des Grundmodus ϕ und das transversale Phasengeschwindigkeits-Profil des 2-Tor-Resonators nach Fig. 4
- Fig. 6, 7, 8:: weitere Ausführungsbeispiele nach der Erfindung;
- Fig. 9:: die Profilfunktion des Grundmodus ϕ und das transversale Phasengeschwindigkeits-Profil des 2-Tor-Resonators nach Fig. 8;
- Fig. 10:: ein weiteres Ausführungsbeispiel eines 2-Tor-Resonators nach der Erfindung; und
- Fig. 11:: ein 4-Spur-transversal modengekoppeltes Resonator-filter nach der Erfindung.

Gleiche Elemente in den Figuren sind dabei mit gleichen Bezugszeichen bezeichnet. Auf die Wiedergabe von elektrischen Anschlußelementen wurde in einigen Figuren verzichtet.

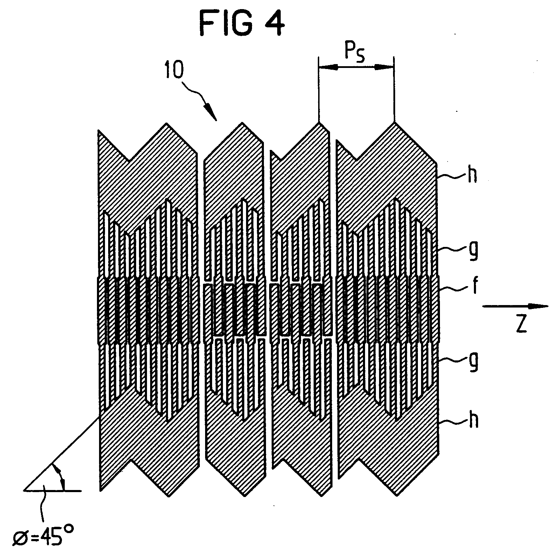

Das 2-Tor-Filter 10 nach Fig. 4, das eine erfindungsgemäße Abwandlung des Filters nach Fig. 1 ist, besitzt einen Gitterbereich 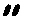 f", der - betrachtet in der Filter-Longitudinalen 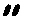 z" - zwischen Reflektoren angeordnete interdigitale Ein- und Ausgangswandler aufweist und im folgenden auch als IDT-Wandlerbereich bezeichnet ist.

Die Reflektoren und Wandler sind über transversal an den Bereich 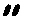 f" angrenzende äußere Gitterbereiche 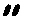 g, g" jeweils mit Sammelschienen 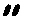 h, h" verbunden, wobei der Abstand zwischen Bereich 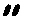 f" und Sammelschienen begrenzt und sein Maß für die verlustlose Führung der gewünschten Moden vorgegeben ist.

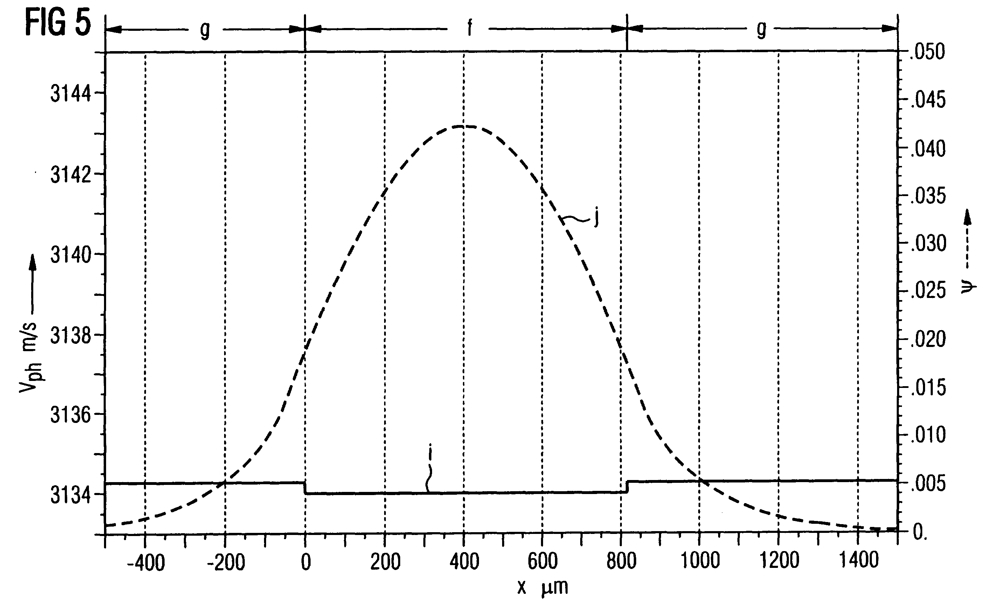

Die Profilfunktion des Grundmodus 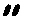 j" und das transversale Phasengeschwindigkeits-Profil 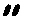 i" dieses Filters ist Fig. 5 entnehmbar. Erkenntlich ist durch geeignete Wahl des Metallisierungsverhältnisses in den äußeren Gitterbereichen 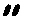 g, g" die Phasengeschwindigkeit in diesen Bereichen so abgesenkt bzw. der Phasengeschwindigkeits-Hub zwischen IDT-Wandlerbereich und diesen Bereichen so niedrig, daß transversale Moden ab einschließlich 2. Ordnung nicht mehr idealerweise verlustlos geführt werden; d.h. daß der störende Einfluß höherer Moden auf die Funktion des Bauelements weitgehend unterbunden wird.

Die Sammelschienen 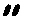 h, h" sind sägezahlförmig strukturiert und zur Filter-Longitudinalen 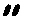 z" parallel ausgerichtet.

Um die Führung höherer transversaler Moden zu unterdrücken, wird der Winkel φ zwischen z-Richtung und Begrenzung der Sammelschine 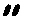 h" so gewählt, daß nicht nur die Totalreflexion vermieden wird, sondern auch die teilweise Reflexion möglichst klein ist. In diesem Sinn bietet sich ein Winkel von φ = 45° an. Es reicht dabei ausdrücklich nicht aus, den Winkel knapp größer als den der Totalreflexion zu wählen, da die Reflektivität als Funktion des Winkels kontinuierlich und relativ flach abnimmt. Da für typische Bauteilgeometrien nur wenige Reflexionen an der Sammelschine 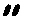 h" in Längsrichtung stattfinden, wäre die Unterdrückung dieser reflektierten Anteile zu gering. Durch die Wahl von 45 Grad für den Winkel werden einfach reflektierte Wellen um 90 Grad abgelenkt, sind somit orthogonal zur Wandleranregung und können daher nicht detektiert werden. Erst durch erneute Reflexion wird die Ausbreitungsrichtung wieder ungefähr in Längsrichtung 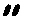 z" liegen. Da in diesem Fall jedoch schon zwei Reflexionen stattgefunden haben müssen, ist die Amplitude bereits um den Faktor r*r reduziert, wobei 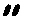 r" der Reflexionskoeffizient für einmalige Reflexion ist. Für r= 0,05 ist die Amplitude der reflektierten Welle also bereits auf r*r = 0,0025 zurückgegangen. Verfolgt man den Lauf einer solchen Welle, so wird diese nach zweimaliger Reflexion zum Wandler versetzt laufen und kann demgemäß ebenfalls nicht detektiert werden.

Die Periode Ps der sägezahnförmigen Sammelschiene 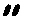 h" ist so zu wählen, daß näherungsweise geometrische Ausbreitung der akustischen Wellen angesetzt werden kann, 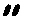 dh" Pₛ >> λ mit der akustischen Wellenlänge λ.

Wahlweise können die Sammelschienen 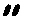 h, h" unter einem geeigneten akustischen Sumpf angeordnet sein, so daß für die Funktion des Bauelements störende Rückreflexionen in den Wandlerbereich ebenfalls unterdrückt werden. Für den Fall, daß dieser nicht eigenreflexionsfrei ist, kann die obige Ausführung der Grenzfläche auch für die Berandung des Sumpfes angewendet werden.

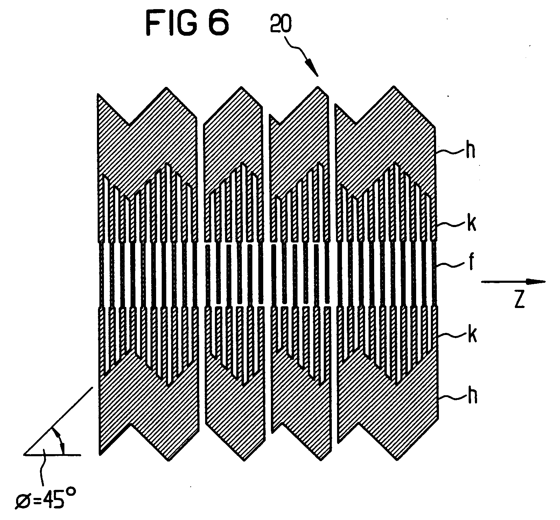

Fig. 6 zeigt eine mögliche Alternative zum äußeren Gitterbereich 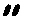 g, g" nach Fig. 4. Die Phasengeschwindigkeit im äußeren Gitterbereich 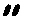 k, k" dieses Filters 20 wird durch eine Erhöhung des Metallisierungsverhältnisses erhöht. Der Vorteil liegt in den niedrigeren ohmschen Verlusten, bedingt durch die breiteren Finger.

Wie aus Fig. 3 hervorgeht, ist der Abfall bzw. die Steigung der Phasengeschwindigkeit mit zunehmendem Metallisierungsverhältnis η im Gitterbereich 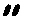 g, g" bzw. 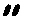 k, k" für kleines bzw. sehr großes Metallisierungsverhältnis η wesentlich größer als für ein η, das ungefähr mit dem Phasengeschwindigkeitsminimum zusammenfällt (in Fig. 3 für η ungefähr gleich 0,7). Jedenfalls ist der Abfall bzw. die Steigung in den Bereichen 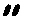 g, g" bzw. 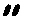 k, k" und 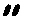 f, r, s t" unterschiedlich. Bei der Herstellung der Oberflächenwellen-Filter wirken sich daher unvermeidliche Schwankungen des Metallisierungsverhältnisses η unterschiedlich auf die Phasengeschwindigkeiten in den verschiedenen Bereichen aus. Dies erschwert die reproduzierbare Herstellung in Bezug auf eine notwendigerweise exakte Einstellung der Phasengeschwindigkeiten.

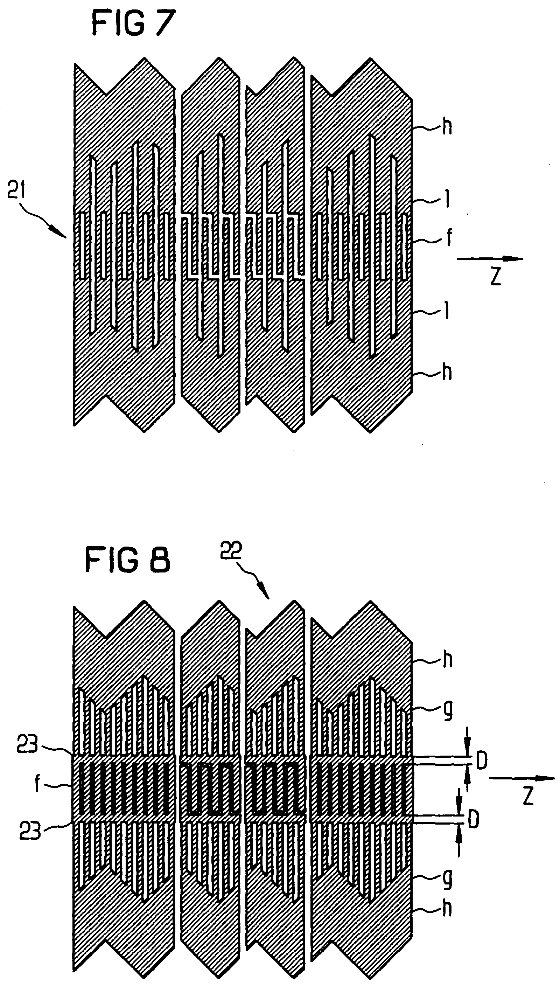

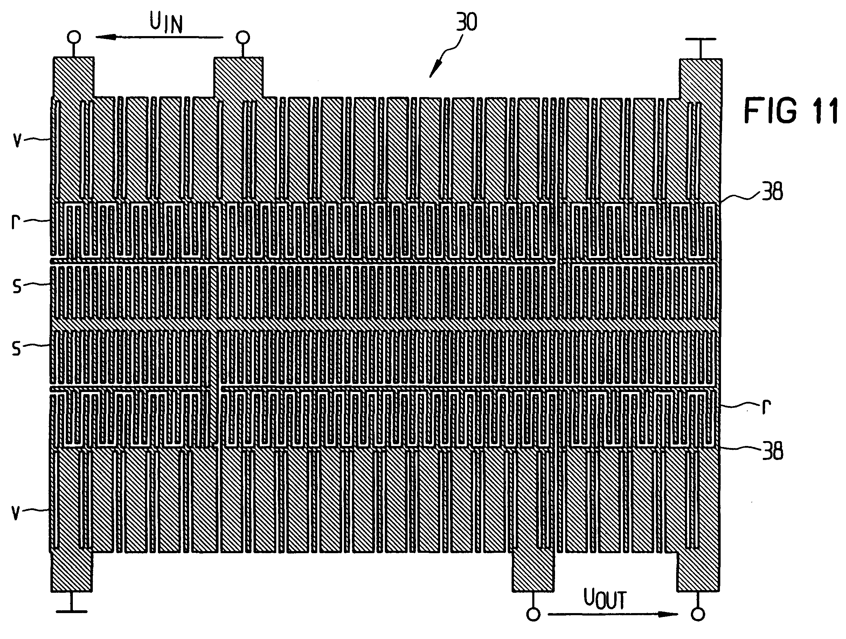

Dieser Nachteil läßt sich durch eine Ausführungsform des Bereiches 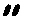 1, 1" bzw. 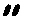 v, v" wie in den Figuren 7 und 11 vermeiden. In beiden Darstellungen wird die Phasengeschwindigkeit als Mittelwert zwischen der Phasenbgeschwindigkeit eines Gitterbereiches mit einem dem Wandlerbereich 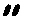 f, r, s, t" ähnlichen Metallisierungsverhältnis und der Phasengeschwindigkeit einer vollmetallisierten Fläche nötiger Länge (in z-Richtung) eingestellt.

Durch die photolithographische Herstellung unterliegt im wesentlichen die Position der Kanten zwischen metallisierter und freier Oberfläche gewissen Schwankungen. Da die vollmetallisierte Fläche weniger Kanten aufweist als ein Gitterbereich gleicher Länge, unterliegt die mittlere Phasengeschwindigkeit der Ausführungsformen 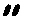 1, 1" bzw. 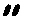 v, v" kleineren Schwankungen als die Ausführungsformen 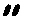 g, g" bzw. 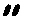 k, k" aus den Figuren 4 und 8 bzw. 6. Dies ist insbesondere dann der Fall, wenn das Metallisierungsverhältnis des Gitterbereiches so gewählt wird, daß die minimale Phasengeschwindigkeit im Gitterbereich vorliegt. Dies ist in Fig. 3 für ein Metallisierungsverhältnis von ungefähr 0,7 der Fall.

Die Ausführungsformen in Fig. 7 und Fig. 11 unterscheiden sich durch die Länge des Gitterbereiches und die Periodizität im Bereich 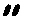 1" bzw. 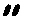 v". In Fig. 7 umfaßt die Periode zwei Gitterperioden des Wandlerbereiches 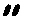 f, r, s, t", und der Anteil des Gitterbereiches umfaßt eine Gitterperiode des Wandlerbereiches 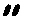 f, r, s, t". Gleichwohl ist kein Finger im Bereich 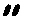 1" zu erkennen. In Fig. 11 umfaßt die Periode 4 Gitterperioden des Wandlerbereiches 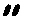 f, r, s, t", und der Anteil des Gitterbereiches umfaßt zwei Gitterperioden des Wandlerbereiches 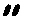 f, r, s, t". Ein Finger ist in diesem Fall zu erkennen. Durch Vorgabe positiver rationaler Zahlen für den Anteil des Gitterbereiches und den Anteil des vollmetallisierten Bereiches läßt sich eine gewünschte Phasengeschwindigkeit mit beliebiger Genauigkeit approximieren. Für die angegebenen Ausführungsformen können mittlere Phasengeschwindigkeiten zwischen den Phasengeschwindigkeiten im Gitterbereich und im vollmetallisierten Bereich eingestellt werden.

Alternativ können mittlere Phasengeschwindigkeiten zwischen den Phasengeschwindigkeiten im vollmetallisierten Bereich und im freien Bereich eingestellt werden, indem der Gitterbereich durch einen freien Bereich ersetzt wird.

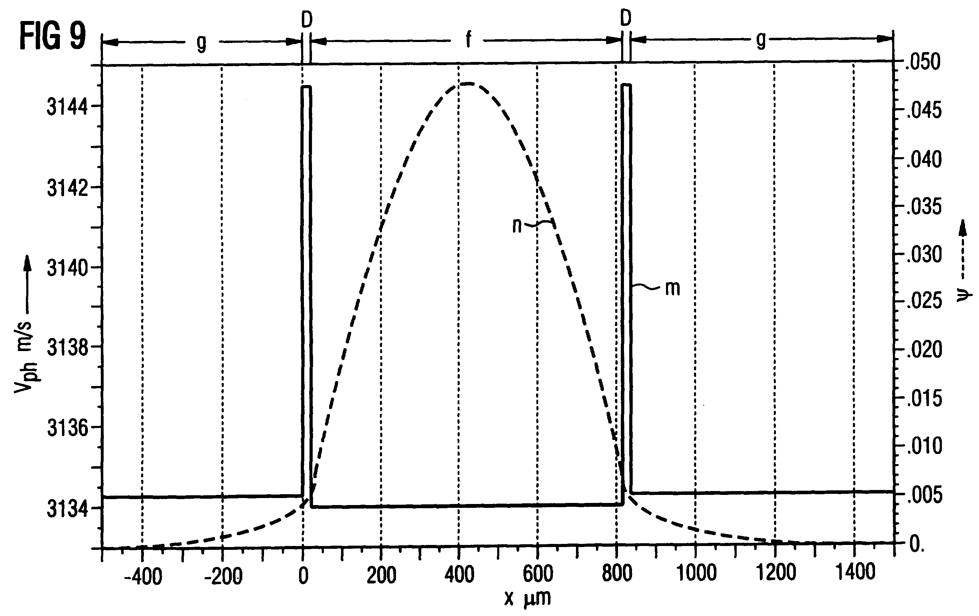

Beim Ausführungsbeispiel eines 2-Tor-Filters 22 nach Fig. 8, dessen Phasengeschwindigkeits-Profil 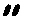 m" und Profilfunktion ϕ in Fig. 9 dargestellt sind, wird bedingt durch die sammelschienenartigen Streifen 23 der Breite 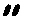 D" der Grundmodus 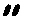 n" stärker auf den IDT-Wandlerbereich 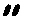 f" konzentriert. Gleichzeitig wird die akustische Energie im äußeren Gitterbereich 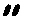 g" herabgesetzt.

Höhere transversale Moden bleiben bei dieser Gitterstruktur ungeführt, d.h. sie strahlen einen Teil der geführten Leistung ab. Mit zunehmender Breite 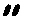 D", der vollmetallisierten Streifen 23 wird diese Abstrahlung jedoch immer weiter verringert, bis für die unendlich große Breite 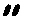 D" wieder die Bedingungen gemäß Filter 1 nach Fig. 1 und 2 vorliegen.

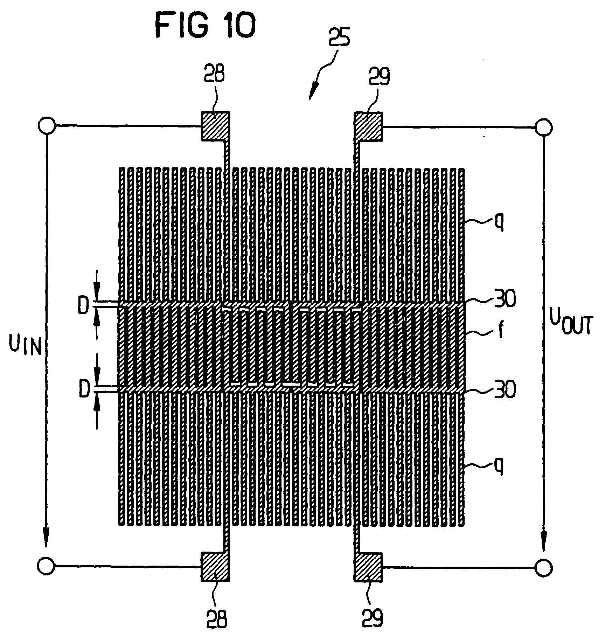

Das Filter 25 nach Fig. 10, bei dem die Ein- und Ausgangsspannungen U_{IN} bzw. U_{OUT} über entsprechende Anschlußelemente 28, 28 bzw. 29, 29 am jeweiligen IDT-Wandler anliegen, weist in Analogie zum Filter nach Fig. 8 unmittelbar an den IDT-Wandlerbereich 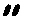 h" angrenzende Sammelschienen 30 auf. Der äußere Gitterbereich 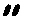 q" erstreckt sich hier zwischen diesen Sammelschienen und dem Bereich höherer Phasengeschwindigkeit, d.h. dem Bauelemente-Teil, dessen Oberfläche nichtmetallisiert ist. Die Sammelschienen dienen in diesem Fall der notwendigen elektrischen Kontaktierung.

Um externe Koppelelemente in kaskadierten TCF-Filtern (s. Transverse coupled resonator filter, z.B. veröffentlicht in 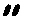 Proceedings of the IEEE, 67, 1979, Fig. 12d", 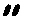 Surface-Acoustic-Wave Resonator Filters", Verfasser L.A. Coldren) und damit hohe Kosten und Streuungen der Filtereigenschaften zu vermeiden, können vier und mehr akustische Spuren 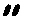 r", 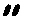 s", 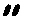 s", 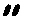 t" transversal gekoppelt weden, wie dies beim 4-Spur-TCF-Filter 30 nach Fig. 11 der Fall ist. Die Anwendung der Erfindung auf diese komplett akustisch gekoppelten Resonator-filter erniedrigt erwünschterweise die Filter-Impedanzen und reduziert die Abstrahlverluste. Durch die relativ großen Spurbreiten wird die Richtwirkung der Ein- und Auskoppelstruktur verbessert, und der Abstand zwischen Ein- und Ausgangswandler wird größer, woraus eine wesentliche Reduktion des direkten akustischen Übersprechens resultiert.

Die Ein- und Ausgangsanschlüsse zu den IDT-Wandlern der Spuren 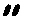 r" und 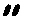 t" sind dabei über die äußeren Gitterstrukturen 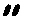 v, v" geführt.

Die Erfindung ist nicht auf die gezeigten und beschriebenen Ausführungsbeispiele beschränkt. Allgemein erstreckt sich die Erfindung bzw. ihre Anwendung auf Wellenleiter der unterschiedlichsten Art, z.B. auf Resonatoren allgemein, auf Z-Weg-Filter, auf Convolver, auf TCF-Filter mit zwei und mehr Spuren und Kombinationen mit Einspur-Resonator-Filtern, auf IIDT-Filter und dergleichen.

## Patentansprüche

1. Akustischer Wellenleiter, insbesondere Oberflächenwellen-Filter, mit einem IDT-Wandlerbereich bevorzugt großer Apertur,
dadurch **gekennzeichnet,**
daß die Phasengeschwindigkeit (vph) im transversal an den IDT-Wandlerbereich (f) angrenzenden äußeren Bereich (g, k, l, q, v) auf einen Betrag eingestellt ist, der zwischen der Phasengeschwindigkeit im IDT-Wandlerbereich und der höheren Phasengeschwindigkeit im Bereich des Wellenleiters mit freier, nichtmetallisierter Oberfläche liegt.

2. Oberflächenwellen-Filter nach Anspruch 1, dadurch gekennzeichnet, daß die Phasengeschwindigkeit im transversal an den IDT-Wandlerbereich (f) angrenzenden Bereich (g, k, l, q, v) auf einem Betrag eingestellt ist, bei dem im IDT-Wandlerbereich ausschließlich Moden erwünschter niedriger Ordnung verlustlos geführt sind.

3. Oberflächenwellen-Filter nach Anspruch 1 und 2, dadurch gekennzeichnet, daß der transversal an den IDT-Wandlerbereich (f) angrenzende äußere Bereich mit einer metallischen Gitterstruktur (g, k, l, q, v) belegt und die Phasengeschwindigkeit in diesem Bereich durch entsprechende Wahl des Metallisierungsverhältnisses (η) der Gitterstruktur eingestellt ist.

4. Oberflächenwellen-Filter nach Anspruch 1 - 3, dadurch gekennzeichnet, daß die metallischen Gitterstrukturen (g, q, v) und die IDT-Wandlerbereiche (f, v) jeweils auf den gegenüberliegenden Seiten von Sammelschienen (23, 30, 38) angeordnet und unmittelbar an diese angeschlossen sind.

5. Oberflächenwellen-Filter nach Anspruch 1 - 3, dadurch gekennzeichnet, daß die IDT-Wandlerbereiche (f) mittelbar über metallische Gitterstrukturen (g, k, l) jeweils mit den Sammelschienen (h) unterschiedlicher Polarität verbunden sind.

6. Oberflächenwellen-Filter nach Anspruch 1 - 3 und 5, dadurch gekennzeichnet, daß der Abstand Sammelschiene - IDT-Wandlerbereich begrenzt und sein Maß durch die verlustlose Führung der gewünschten Moden vorgegeben ist.

7. Oberflächenwellen-Filter nach Anspruch 1 - 3, 5 und 6, dadurch gekennzeichnet, daß - betrachtet zur Filter-Longitudinalen 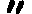 z" - die Sammelschienen abweichend von der Geraden so strukturiert sind, daß die Totalreflexion von unerwünschten Moden höherer Ordnung unterbunden und ihre teilweise Reflexion möglichst gering ist.

8. Oberflächenwellen-Filter nach Anspruch 1 und 7, dadurch gekennzeichnet, daß die Bereiche (h) der Sammelschienen mäanderförmig strukturiert sind.

9. Oberflächenwellen-Filter nach Anspruch 1, 7 und 8, dadurch gekennzeichnet, daß die Bereiche (h) der Sammelschienen sägezahnförmig strukturiert sind.

10. Oberflächenwellen-Filter nach Anspruch 9, dadurch gekennzeichnet, daß die Sammelschienen unter einem Winkel φ ∼ 45° zur Filter-Longitudinalen 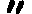 z" geneigt sind.

11. Oberflächenwellen-Filter nach Anspruch 8 - 10, dadurch gekennzeichnet, daß die Struktur der Sammelschienen (h) eine Periodizität Ps >> λ aufweist, wobei mit λ die akustische Wellenlänge bezeichnet ist.

12. Oberflächenwellen-Filter nach Anspruch 1 - 6, dadurch gekennzeichnet, daß dieSammelschienen zur Bedämpfung störender akustischer Schallwellen mit einer Absorptionsschicht bedeckt sind.

13. Oberflächenwellen-Filter nach Anspruch 7 - 12, dadurch gekennzeichnet, daß die Absorptionsschicht entsprechend Anspruch 7 bis 12 strukturiert ist.

14. Oberflächenwellen-Filter nach Anspruch 1 - 5, dadurch gekennzeichnet, daß im an den IDT-Wandlerbereich (f, r, v) angrenzenden äußeren Gitterbereich (z, v) eine gewünschte mittlere Phasengeschwindigkeit durch eine - betrachtet zur Filter-Longitudinalen 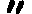 z" - abschnittsweise Aufteilung in Gitterbereich, vollmetallisierten Bereich und freien Bereich erzielt ist.

15. Oberflächenwellen-Filter nach Anspruch 1 - 5 und 14, dadurch gekennzeichnet, daß die metallische Gitterstruktur (g, k, l, q, v) streifenförmig ist und das Metallisierungsverhältnis (η) durch Breitenwahl der einzelnen Streifen bestimmt ist.

16. Oberflächenwellen-Filter nach Anspruch 1 - 15, dadurch gekennzeichnet, daß die IDT-Wandlerfinger unterschiedlicher Polarität unmittelbar mit Sammelschienen (23) verbunden sind, die über metallische Gitterstrukturen (g) mit weiteren, mäander- insbesondere sägezahnförmigen Sammelschienen (h) verbunden sind.

17. Oberflächenwellen-Filter nach Anspruch 1 - 16, dadurch gekennzeichnet, daß als Substratmaterial für das Filter Quarz vorgesehen ist.
